# EUROPEAN PATENT APPLICATION

(11) **EP 4 510 791 A1**
(43) Date of publication of application: **19.02.2025**
(21) Application number: 23788215.4
(22) Date of filing: 04.04.2023
(51) Int. Cl.: H05K 7/20, G06F 1/20, G11B 33/14

(54) **ELECTRONIC DEVICE**

(30) Priority: 11.04.2022 JP 2022065381
(71) Applicant: Sony Interactive Entertainment Inc., Tokyo 108-0075 (JP)
(72) Inventor: KITAMURA, Yuuki, Tokyo 108-0075 (JP); ETO, Kazutaka, Tokyo 108-0075 (JP); TAMAKI, Yuta, Tokyo 108-0075 (JP); AOKI, Keiichi, Tokyo 108-0075 (JP); OOTORI, Yasuhiro, Tokyo 108-0075 (JP)
(74) Representative: D Young & Co LLP
(86) International application number: PCT/JP2023/013936
(87) International publication number: WO 2023/199796

(57) **Abstract**

Provided is an electronic device that can reduce dust and so forth that adhere to a ventilation region of a heat generating part or a heat radiating part. An electronic device (10) includes a power supply unit (40), and a housing (20) that has the power supply unit (40) accommodated therein and that has an intake port (21h) formed therein. The intake port (21h) is positioned to the right with respect to the power supply unit (40). The power supply unit (40) has, on a side thereof directed to the right of the power supply unit (40), an intake region (42A, 42B) for allowing passage therethrough of air from the outside toward the inside of a case (41) of the power supply unit (40). A dustproof wall (29) is formed between the intake region (42A, 42B) and the intake port (21h) and stands uprightly in an upward and downward direction.

## Description

### [Technical Field]

The present disclosure relates to an electronic device.

### [Background Art]

A circuit board, a cooling fan or a heat sink for cooling a heat generating part on the circuit board, and so forth are arranged inside an electronic device such as a game device, a personal computer, or a server computer. A vent hole for introducing air from the outside or discharging air from the inside is formed on a housing that has the circuit board and so forth accommodated therein. An example of such an electronic device is disclosed in PCT Patent Publication No. WO2021/193879.

### [Summary]

### [Technical Problem]

Even when an electronic device is not in use, dust, dirt, or the like sometimes enters its housing through a vent hole. Depending upon the posture of the electronic device, the dust or the like sometimes adheres to a part that is arranged in the housing and that requires cooling (for example, a heat sink or a power supply unit).

### [Solution to Problem]

An electronic device proposed in the present disclosure includes a part and a housing that has the part accommodated therein and that has a vent hole formed therein. The vent hole is positioned in a first direction with respect to the part. The part has, on a side thereof directed to the first direction, a ventilation region for allowing passage therethrough of air from the outside toward the inside of the part or from the inside toward the outside of the part. A dustproof wall is formed between the ventilation region of the part and the vent hole and stands uprightly in a second direction intersecting the first direction. With this electronic device, dust and so forth that adhere to the ventilation region of the part can be reduced.

### [Brief Description of Drawings]

[FIG. 1A]

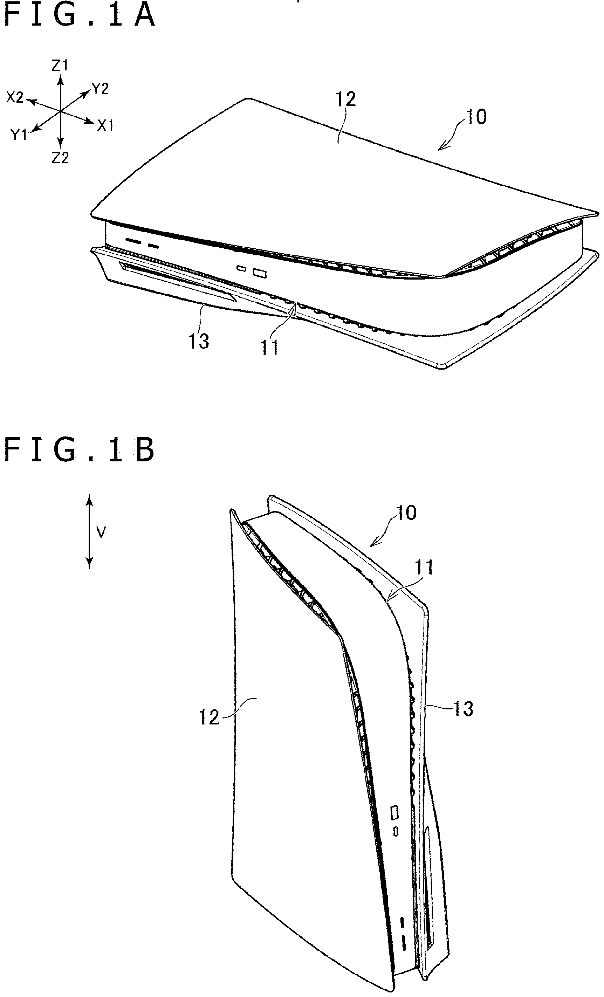

   FIG. 1A is a perspective view depicting an example of an electronic device proposed in the present disclosure.
[FIG. 1B]
   FIG. 1B is a perspective view depicting a situation in which the electronic device depicted in FIG. 1A is placed in a vertical posture.
[FIG. 2]

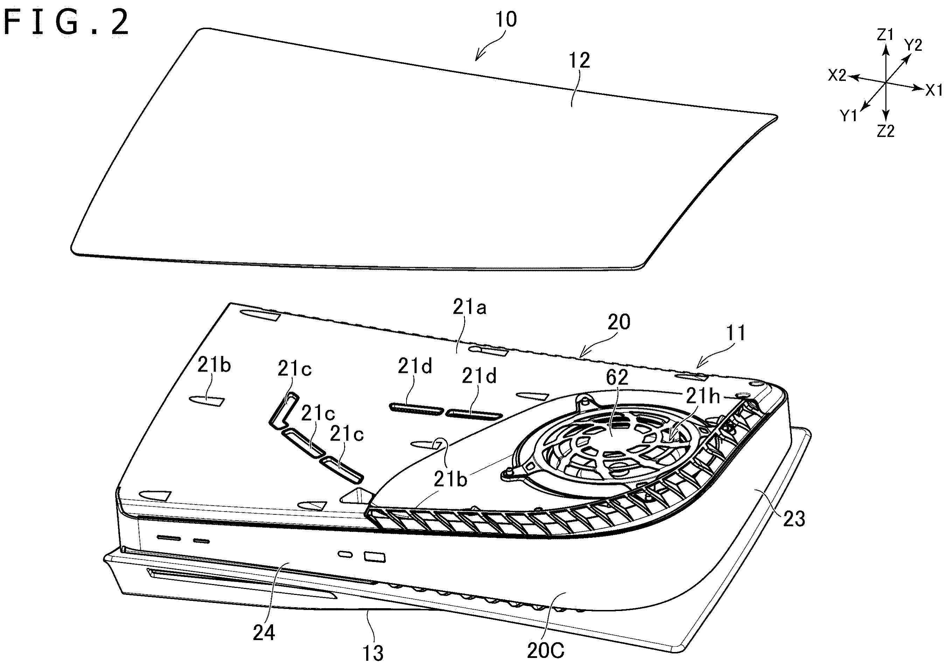

   FIG. 2 is an exploded view depicting a situation in which an upper panel is removed from a device main body.
[FIG. 3]

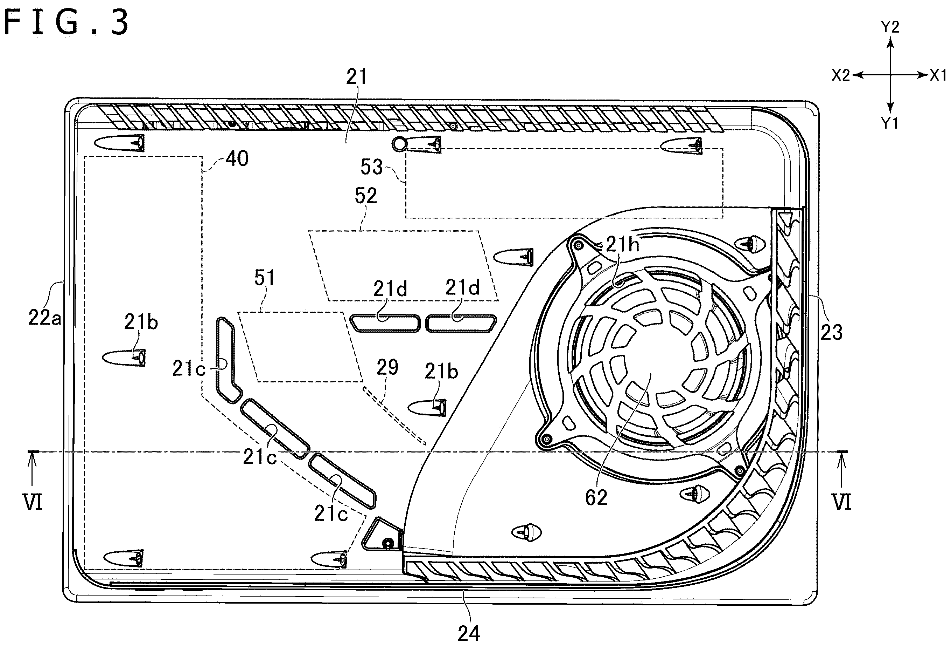

   FIG. 3 is a top plan view of the device main body.
[FIG. 4A]

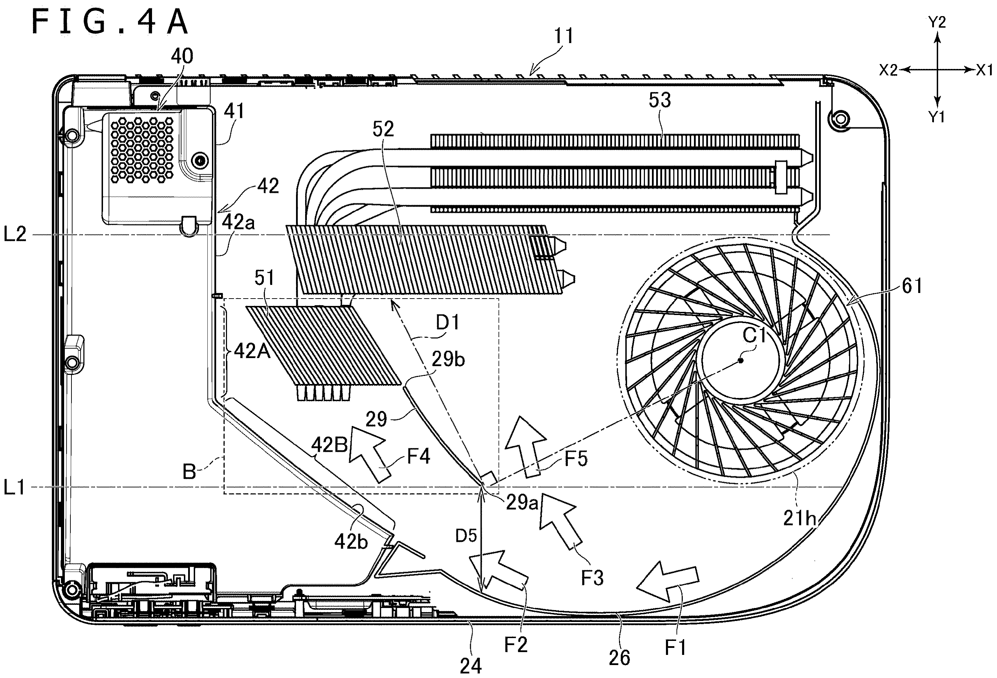

   FIG. 4A is a top plan view depicting parts arranged in a housing of the device main body.
[FIG. 4B]

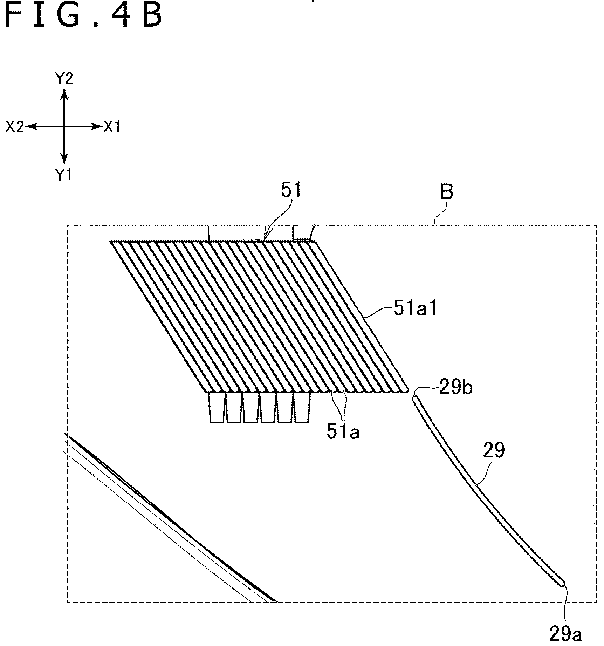

   FIG. 4B is an enlarged view of a region indicated by a broken line B in FIG. 4A.
[FIG. 4C]

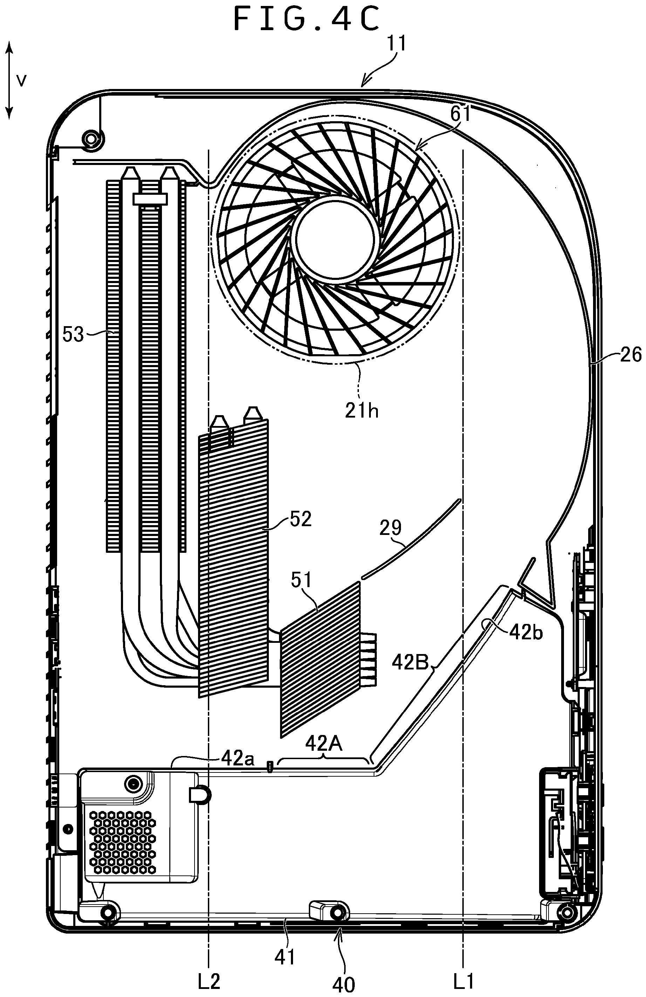

   FIG. 4C is a view depicting the parts when the electronic device is placed in the vertical posture as depicted in FIG. 1B.
[FIG. 5]

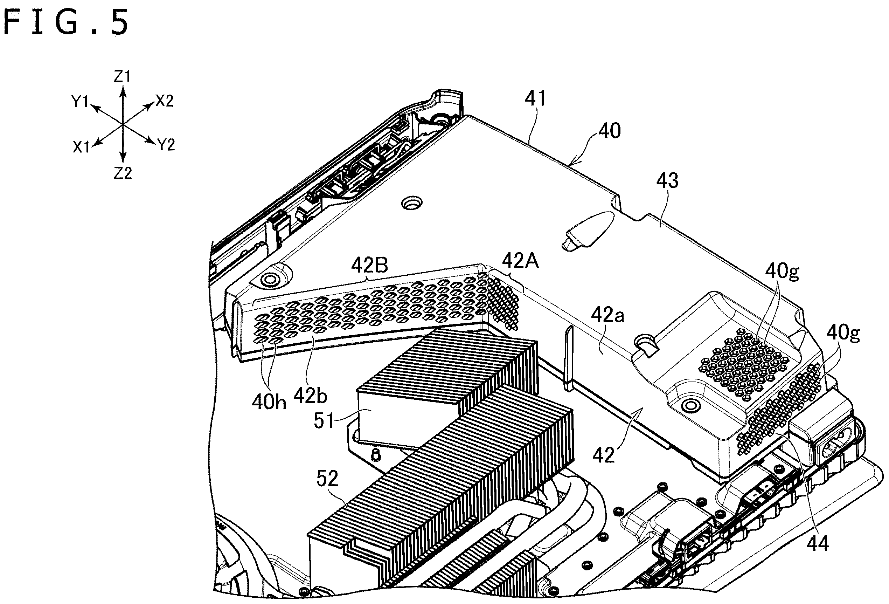

   FIG. 5 is a perspective view depicting an intake region of a power supply unit.
[FIG. 6]

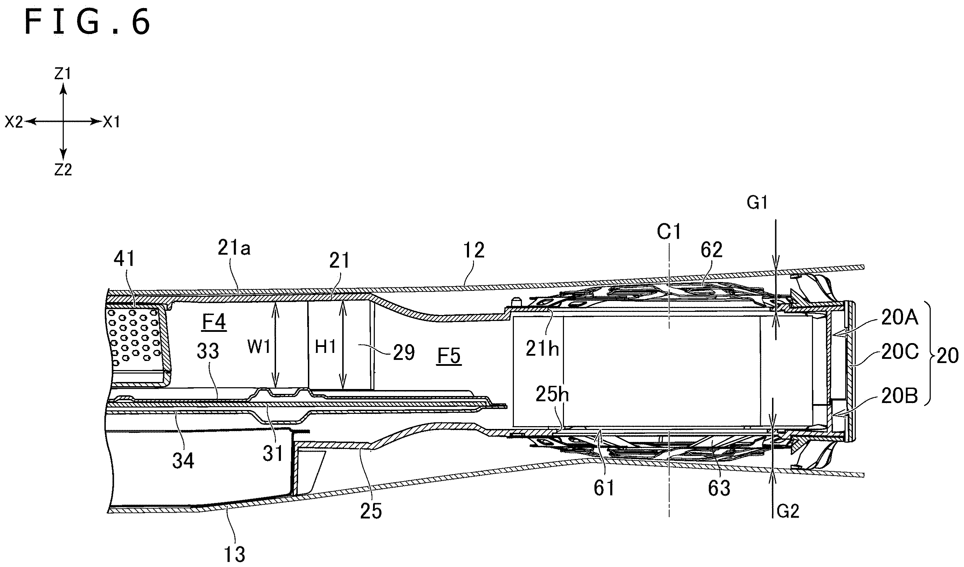

   FIG. 6 is a sectional view taken along line VI-VI depicted in FIG. 3.

### [Description of Embodiments]

In the following, an electronic device proposed in the present disclosure is described with reference to the drawings. FIGS. 1A and 1B are perspective views of an electronic device 10 that is an example of the electronic device proposed in the present disclosure. In FIG. 1A, the electronic device 10 is placed in a horizontal posture and, in FIG. 1B, the electronic device 10 is placed in a vertical posture. FIG. 2 depicts a situation in which an upper panel 12 is removed from a device main body 11 of the electronic device 10.

In the following description, reference signs X1 and X2 depicted in FIG. 1A represent a rightward direction and a leftward direction, respectively; reference signs Y1 and Y2 represent a forward direction and a rearward direction, respectively; and reference signs Z1 and Z2 represent an upward direction and a downward direction, respectively. The directions mentioned are defined for illustrating shapes and relative positional relations of components (parts, members, and portions) of the electronic device 10, and do not restrict the posture of the electronic device 10 in use. Further, in FIGS. 1B and 4C, an arrow mark V indicates an upward and downward direction in the vertical posture of the electronic device 10 hereinafter described.

As depicted in FIGS. 1A and 2, the electronic device 10 may include the device main body 11 and the upper panel 12 that covers an upper face 21a of the device main body 11. As depicted in FIGS. 1A and 2, the upper panel 12 may have a size sufficient to cover the entire upper face 21a of the device main body 11, or may have a size sufficient to cover only part of the upper face 21a (for example, a portion or portions at which an intake port 21h or discharge openings 21c and 21d hereinafter described are formed).

The upper panel 12 is removably provided on the device main body 11. The upper panel 12 has attachment portions (attachment projections) that can be removably attached to a plurality of attachment portions (attachment holes) 21b formed in the upper face 21a of the device main body 11. Further, the electronic device 10 may include a lower panel 13 that covers a lower face of the device main body 11.

### [Vertical Posture and Horizontal Posture of Electronic device]

The electronic device 10 can be placed in the horizontal posture (FIG. 1A) and the vertical posture (FIG. 1B). In the horizontal posture, the electronic device 10 is placed in such a manner that a lower face of the electronic device 10 (lower panel 13 in the example depicted in FIG. 1A) comes to the lower side. In the vertical posture, the electronic device 10 is placed in such a manner that, for example, a left side face of the electronic device 10 (left side face 22a of the device main body 11 (refer to FIG. 3)) comes to the lower side.

In the present specification, the "vertical posture" is a posture in which a vent hole (intake port 21h hereinafter described (refer to FIG. 2)) is positioned above a heat generating part (for example, a power supply unit 40 hereinafter described) or a heat radiating part. The intake port 21h and the power supply unit 40 are hereinafter described in detail.

The electronic device 10 may have such a structure that, when it is in the horizontal posture (refer to FIG. 1A), it is placed directly on and supported stably by a surface (arrangement face) of a table, a floor, or the like, or may have such a structure that a stand member (not depicted) is attached to the electronic device 10 such that the electronic device 10 is supported stably on the arrangement face. Similarly, the electronic device 10 may have such a structure that, when it is in the vertical posture (refer to FIG. 1B), it is placed directly on and supported stably by the arrangement face, or may have such a structure that a stand member (not depicted) is attached to the electronic device 10 such that the electronic device 10 is supported stably on the arrangement face.

The electronic device 10 may not be supposed for use in such two postures as described above. The electronic device 10 may be an electronic device that is assumed to be used, for example, only in a posture (vertical posture) in which the vent hole (intake port 21h hereinafter described (refer to FIG. 2)) is positioned above a heat radiating part or a heat generating part (power supply unit 40 hereinafter described).

### [Device Main Body]

The device main body 11 includes a housing 20 (refer to FIG. 2). As depicted in FIG. 4A, the housing 20 has accommodated therein a cooling fan 61, the power supply unit 40, heat sinks (heat radiating devices) 51, 52, and 53, and so forth. Further, the housing 20 has accommodated therein a circuit board 31 (refer to FIG. 6). On the circuit board 31, various electronic parts such as a central processing unit (CPU) and a graphical processing unit (GPU) are mounted.

The power supply unit 40 uses electric current supplied from an external power supply, to supply driving power to various parts such as the CPU included in the device main body 11. The power supply unit 40 includes a case 41 (refer to FIG. 5). The case 41 accommodates therein a circuit board including a transformer, a rectification circuit, and so forth.

The heat sinks 51, 52, and 53 are directly connected to a heat generation part such as the CPU or are thermally connected to a heat generating part through a heat pipe. The cooling fan 61 forms an airflow that passes through the inside of the case 41 of the power supply unit 40 or passes through the heat sinks 51, 52, and 53.

### [Housing]

As depicted in FIG. 2, the housing 20 has an upper wall 21 that covers the upper side of the power supply unit 40, the heat sinks 51, 52, and 53, and so forth and that configures the upper face 21a of the device main body 11. Further, the housing 20 may have a right wall 23 (refer to FIG. 3) that configures a right side face of the device main body 11, a front wall 24 (refer to FIG. 3) that configures a front face 24a of the device main body 11, and a lower wall 25 (refer to FIG. 6) that configures the lower face of the device main body 11. The housing 20 may include a plurality of members that are combined with each other. For example, the housing 20 may include an upper housing 20A (refer to FIG. 6) and a lower housing 20B (refer to FIG. 6) that are combined with each other in the upward and downward direction. Further, the housing 20 may include an exterior panel 20C (refer to FIG. 2) that surrounds front faces and side faces of the upper housing 20A and the lower housing 20B.

### [Intake Port and Air Flow Path]

As depicted in FIG. 2, the intake port 21h is formed on the housing 20. The intake port 21h is formed, for example, in the upper wall 21 of the housing 20. The cooling fan 61 (refer to FIG. 6) is arranged in such a manner that, for example, an axial line C1 thereof is directed in the upward and downward direction, and the intake port 21h is formed on the upper side of the cooling fan 61. As depicted in FIG. 6, an intake port 25h may be formed also in the lower wall 25 of the housing 20. This intake port 25h is formed on the lower side of the cooling fan 61. To the intake ports 21h and 25h, protective plates 62 and 63 having formed therein a plurality of openings through which air is to pass may be attached in such a manner that they cover the intake ports 21h and 25h, respectively.

When the cooling fan 61 is driven, external air is introduced into the housing 20 through the intake ports 21h and 25h. The air introduced in the housing 20 is spread in radial directions of the cooling fan 61 and flows along air flow paths formed between the upper wall 21 of the housing 20 and the circuit board 31 (more particularly, upper side electromagnetic shield 33 hereinafter described). In particular, air flows F1 to F5 are formed between the upper wall 21 of the housing 20 and the circuit board 31 as depicted in FIG. 4A. A flow path wall 26 that defines the flow paths of the air flows F1 to F5 may be formed in the housing 20. The flow path wall 26 may be curved in such a manner as to surround the cooling fan 61. An air flow path may be formed also between the lower wall 25 of the housing 20 and the circuit board 31 (more particularly, lower side electromagnetic shield 34).

As depicted in FIG. 6, when the upper panel 12 is attached to the upper face 21a of the device main body 11, a gap G1 may be secured between the intake port 21h and the upper panel 12. Similarly, when the lower panel 13 is attached to the lower face of the device main body 11, a gap G2 may be secured between the intake port 25h and the lower panel 13. The gaps G1 and G2 are open toward the front side and the right side of the electronic device 10 and function as air flow paths from the outside of the electronic device 10 to the intake ports 21h and 25h.

It is to be noted that the positions of the intake ports 21h and 25h are not limited to those of the example depicted in FIG. 6. For example, an intake port may be formed in the right wall 23 of the housing 20. In this case, the cooling fan 61 may be arranged in such a manner that the axial line C1 thereof is directed in the rightward and leftward direction. Further, the number of intake ports may not be two. For example, the intake port 25h may not be formed in the lower wall 25.

In the example described in the present disclosure, as depicted in FIG. 4A, three heat sinks 51, 52, and 53 are arranged in the housing 20. The three heat sinks 51, 52, and 53 are lined up in the order of the first heat sink 51, the second heat sink 52, and the third heat sink 53 from the front side of the electronic device 10.

The air flows F1 to F3 formed in the housing 20 are guided by the flow path wall 26 and flow substantially toward the left side (power supply unit 40 side) from the cooling fan 61 as depicted in FIG. 4A. The air flow F4 is a downstream air flow of the air flow F2 and is formed toward the first heat sink 51. Part of the air flow F4 having passed through the first heat sink 51 passes through the second heat sink 52. The air flow F5 is a downstream air flow of the air flow F3 and is formed toward the second heat sink 52. Part of the air flow F5 having passed through the second heat sink 52 passes through the third heat sink 53. The air having passed through the heat sinks 51, 52, and 53 is discharged to the rear side of the electronic device 10.

It is to be noted that the arrangement and the number of heat sinks in the housing 20 are not limited to those of the example depicted in FIG. 4A and so forth. The number of heat sinks may be one or may be two.

### [Arrangement of Power Supply Unit]

As depicted in FIG. 3, the intake port 21h is formed at a right portion of the housing 20. Meanwhile, the power supply unit 40 is arranged at a left portion of the housing 20. The intake port 21h is located to the right of the power supply unit 40. The case 41 of the power supply unit 40 has, on the right side thereof (side directed to the intake port 21h), intake regions (ventilation regions) 42A and 42B (refer to FIG. 5). The intake regions 42A and 42B have a plurality of intake holes 40h (refer to FIG. 5) formed therein. In particular, as depicted in FIG. 5, a plurality of intake holes 40h are formed in a right wall 42 of the case 41, and the regions in which the intake holes 40h are formed are the intake regions 42A and 42B.

As depicted in FIG. 4A, the right wall 42 of the case 41 has a first right wall 42a formed along the forward and rearward direction and a second right wall 42b that extends diagonally to the front and the right from the first right wall 42a. The intake holes 40h are formed in the second right wall 42b and a front portion of the first right wall 42a. The intake regions 42A and 42B of the right wall 42 face the flow path of the air flow F4 described hereinabove. Accordingly, part of the air flow F4 formed by driving of the cooling fan 61 is introduced into the case 41 through the intake holes 40h.

As depicted in FIG. 5, the case 41 has a plurality of exhaust holes 40g for exhausting air therethrough. The plurality of exhaust holes 40g may be formed at a rear portion of the case 41. More particularly, the plurality of exhaust holes 40g may be formed at a rear portion of an upper wall 43 of the case 41 and a rear wall 44 of the case 41. The position at which the exhaust holes 40g are formed is not limited to that of the example depicted in FIG. 5. For example, the exhaust holes 40g may be formed in a left wall of the case 41.

### [Dustproof Wall]

When the electronic device 10 is in the horizontal posture (refer to FIG. 1A), the intake port 21h is located to the right of the intake regions 42A and 42B of the right wall 42 of the power supply unit 40. Accordingly, when the electronic device 10 is in the vertical posture (refer to FIG. 1B), the intake port 21h is positioned above the intake regions 42A and 42B as depicted in FIG. 4C. By positioning the intake port 21h at an upper portion of the electronic device 10 when the electronic device 10 is driven, dust and so forth sucked in through the intake port 21h can be reduced. However, if the electronic device 10 remains placed in the vertical posture for a long period of time in a state in which it is not used, then dust or the like sucked in through the intake port 21h adheres little by little to the intake regions of the case 41.

Therefore, the electronic device 10 has a dustproof wall 29 as depicted in FIGS. 4A and 4C. The dustproof wall 29 is formed between the intake port 21h and the intake regions 42A and 42B of the power supply unit 40. Further, the dustproof wall 29 stands uprightly along the upward and downward direction (Z1-Z2 direction) in the horizontal posture of the electronic device 10. In particular, the dustproof wall 29 stands uprightly in a direction intersecting the direction (the rightward direction) in which the intake port 21h is located with respect to the intake regions 42A and 42B. With this structure, when the electronic device 10 is placed in the vertical posture, dust or the like that enters through the intake port 21h and adheres to the intake regions 42A and 42B of the power supply unit 40 can be reduced by the dustproof wall 29.

With reference to FIG. 4A, a line L1 is a straight line that passes a front end of the intake port 21h and extends in the rightward and leftward direction, and another line L2 is a straight line that passes a rear end of the intake port 21h and extends in the rightward and leftward direction. At least part of the dustproof wall 29 is located between the lines L1 and L2. Consequently, when the electronic device 10 is placed in the vertical posture, the dustproof wall 29 is positioned below the intake port 21h as depicted in FIG. 4C. As a result, dust or the like that enters through the intake port 21h and adheres to the intake regions 42A and 42B of the power supply unit 40 can be reduced effectively by the dustproof wall 29.

In the example described in the present disclosure, a front end 29a of the dustproof wall 29 is substantially positioned on the line L1. The front end 29a of the dustproof wall 29 may cross the line L1 forward. Meanwhile, a rear end 29b of the dustproof wall 29 is positioned on the front side with respect to the line L2. Behind the dustproof wall 29, the first heat sink 51 is arranged as hereinafter described in detail, and also the first heat sink 51 reduces the dust or the like that adheres to the intake regions 42A and 42B of the power supply unit 40 when the electronic device 10 is placed in the vertical posture. Unlike the example depicted, the rear end 29b of the dustproof wall 29 may cross the line L2 rearward.

### [Height of Dustproof Wall]

The dustproof wall 29 extends downward from the upper wall 21 of the housing 20 as depicted in FIG. 6. Between the intake port 21h and the intake regions 42A and 42B formed on the case 41 of the power supply unit 40, the flow paths for the air flows F1 to F5 (refer to FIG. 4A) are formed. A height H1 of the dustproof wall 29 may be greater than one half of a width W1 in the upward and downward direction of the air flow paths formed in the housing 20. This can effectively reduce dust or the like that enters through the intake port 21h and adheres to the intake regions 42A and 42B of the right wall 42 of the case 41.

The height H1 of the dustproof wall 29 may preferably be greater than two thirds of the width W1 of the air flow paths in the upward and downward direction. More preferably, the height H1 of the dustproof wall 29 may be greater than three fourths of the width W1 of the air flow paths in the upward and downward direction. Further preferably, the height H1 of the dustproof wall 29 may be substantially equal to the width W1 of the air flow paths in the upward and downward direction.

As depicted in FIG. 6, the upper side of the circuit board 31 is covered with the electromagnetic shield 33. The width W1 of the air flow paths in the upward and downward direction may be the distance between the electromagnetic shield 33 and the upper wall 21 of the housing 20 at the position at which the dustproof wall 29 is formed.

Between a lower end of the dustproof wall 29 and the electromagnetic shield 33, a gap for absorbing a tolerance may be formed. Between the lower end of the dustproof wall 29 and the electromagnetic shield 33, a member having a cushioning property for filling the gap may be arranged.

### [Position and Posture of Dustproof Wall]

The dustproof wall 29 is formed in the housing 20. In particular, the housing 20 is formed from resin, and the dustproof wall 29 is formed integrally with the housing 20. This can suppress an increase in the number of parts. The dustproof wall 29 is formed on the upper wall 21 of the housing 20. The upper wall 21 is a wall that covers an entire part that has the housing 20 accommodated therein. By forming the dustproof wall 29 on such an upper wall 21, the degree of freedom in position and posture of the dustproof wall 29 can be secured.

For example, the dustproof wall 29 is preferably formed along a direction of an air flow in the housing 20. In the example described in the present disclosure, when the cooling fan 61 is driven, formed are the air flows F1 to F5 which are spread in the radial directions of the cooling fan 61 and are curved around the axial line C1. Desirably, the dustproof wall 29 is formed along the direction of the air flows F1 to F5.

As depicted in FIG. 4A, a line D1 tangential to a circle centered at the axial line C1 of the cooling fan 61 extends to the rear and the left in such a manner that it is inclined with respect to the forward and rearward direction (Y1-Y2 direction) and the rightward and leftward direction (X1-X2 direction) of the electronic device 10. Desirably, the dustproof wall 29 is inclined with respect to the forward and rearward direction and the rightward and leftward direction as with this tangential line D1. With this posture of the dustproof wall 29, air resistance arising from the dustproof wall 29 can be reduced.

The dustproof wall 29 is spaced from the intake regions 42A and 42B of the right wall 42 of the power supply unit 40 toward the right side (toward the cooling fan 61). This can reduce resistance arising from the dustproof wall 29 to an air flow to be sent to the power supply unit 40.

In the example described in the present disclosure, a flow path for the air flow F4 is formed between the dustproof wall 29 and the intake regions 42A and 42B as depicted in FIG. 4A. In the middle of the flow path of the air flow F4, the first heat sink 51 is arranged. In other words, the dustproof wall 29 is spaced to the right from the intake regions 42A and 42B such that the air flow F4 to be supplied to the first heat sink 51 is secured.

It is to be noted that the part that is arranged in the middle of the flow path of the air flow F4 is not limited to the heat sink 51. In other words, in the middle of the flow path of the air flow F4, a heat generating device or a heat radiating device different from a heat sink may be arranged.

As depicted in FIG. 4A, the dustproof wall 29 extends forward from the position of the first heat sink 51. More particularly, the dustproof wall 29 extends diagonally to the front and the right from the position of the first heat sink 51. A distance D5 is secured between the front end 29a of the dustproof wall 29 and the flow path wall (curved wall) 26 that defines the flow paths of the air flows F1 and F2. By securing this distance D5, the flow paths of the air flows F2 and F4 that avoid the dustproof wall 29 are formed.

The first heat sink 51 has a plurality of fins 51a lined up in the rightward and leftward direction as depicted in FIG. 4B. Also, the fins 51a extend to the front and the right in such a manner that they are inclined with respect to the forward and rearward direction and the rightward and leftward direction of the electronic device 10. The dustproof wall 29 extends in a direction along the fins 51a. This makes it possible for the air flow F4 formed along the dustproof wall 29 to pass through the first heat sink 51 smoothly.

As depicted in FIG. 4B, the dustproof wall 29 extends in a direction along a fin 51a1, which is positioned at the right end from among the plurality of fins 51a configuring the first heat sink 51, from the fin 51a1. In other words, the dustproof wall 29 is arranged in such a manner that an end face of the fin 51a1 and an end face of the dustproof wall 29 face each other. The dustproof wall 29 and the fin 51a1 extend to the front and the right.

### [Exhaust Opening for Dust]

As depicted in FIG. 3, discharge openings 21d are formed in the upper wall 21 of the housing 20. The discharge openings 21d are positioned on the downstream of the air flow F5 (refer to FIG. 4A) with respect to the dustproof wall 29. The air flow F5 is an air flow formed between the cooling fan 61 (intake port 21h) and the dustproof wall 29. Dust and so forth accumulating on a right side face (side face on the intake port 21h side) of the dustproof wall 29 are moved to the downstream by the air flow F5. Then, the dust and so forth can be discharged through the discharge openings 21d. For example, a user can use a device such as a cleaner to suck the dust and so forth out through the discharge openings 21d.

As depicted in FIG. 3, the discharge openings 21d are formed along a front face (face on the upstream side of the air flow F5) of the second heat sink 52 that receives the air flow F5. With this arrangement of the discharge openings 21d, even if dust and so forth accumulate on the front face of the second heat sink 52 (on front edges of plurality of fins) due to the air flow F5, the dust and so forth can be discharged through the discharge openings 21d. Each discharge opening 21d may have a shape elongated in a direction along the front face of the second heat sink 52.

The structure for discharging dust and so forth accumulating on the side face of the dustproof wall 29 is not limited to that of the example described here. For example, a discharge opening may be formed along the right side face of the dustproof wall 29.

As depicted in FIG. 3, a discharge opening 21c is formed in the upper wall 21 of the housing 20. The discharge opening 21c is located, for example, on the right side (intake port 21h side) of the intake regions 42A and 42B of the right wall 42 of the power supply unit 40. Also in a case where dust and so forth accumulate in the intake regions 42A and 42B due to the air flow F4 formed by the cooling fan 61, the dust and so forth can be discharged through the discharge opening 21c.

As depicted in FIG. 3, a plurality of discharge openings 21c may be formed in the upper wall 21 in such a manner that they are lined up along the intake regions 42A and 42B. Further, each discharge opening 21c may have a shape elongated in a direction along the intake regions 42A and 42B.

The electronic device 10 has the upper panel 12 (FIG. 1A) that is to be attached to the upper face 21a of the device main body 11. The discharge openings 21c and 21d are covered with the upper panel 12. When the upper panel 12 is attached to the upper face 21a, the discharge openings 21c and 21d may be closed up with the upper panel 12. The user can discharge dust and so forth by removing the upper panel 12 from the device main body 11.

### [Conclusion]

(1) The electronic device proposed in the present disclosure includes a part (for example, a power supply unit 40) and a housing that has the part accommodated therein and that has a vent hole formed therein. The vent hole is positioned in a first direction with respect to the part, and the part has, on a side thereof directed to the first direction, a ventilation region for allowing passage therethrough of air from the outside toward the inside of the part or from the inside toward the outside of the part. A dustproof wall is formed between the ventilation region of the part and the vent hole and stands uprightly in a second direction intersecting the first direction. With this electronic device, dust and so forth that adhere to the ventilation region of the part can be reduced.
(2) In the electronic device of (1), the housing may have therein an air flow path formed between the vent hole and the ventilation region of the part, the housing may have a wall portion that defines the air flow path, and the wall portion may have an opening (for example, a discharge opening 21d) formed at a position downstream of an air flow with respect to the dustproof wall.
(3) In the electronic device of (1) or (2), an air flow path may be formed between the vent hole and the ventilation region of the part, and the height of the dustproof wall in the second direction may be equal to or greater than one half of the width of the air flow path in the second direction. This can effectively reduce dust and so forth that adhere to the ventilation region of the part.
(4) In the electronic device of (1) or (2), an air flow path may be formed between the vent hole and the ventilation region of the part, and the height of the dustproof wall in the second direction may be equal to or greater than two thirds of the width of the air flow path in the second direction.
(5) In the electronic device of any one of (1) to (4), the electronic device may further include a cooling fan accommodated in the housing, and the dustproof wall may be arranged along an air flow that is formed by driving of the cooling fan. This can suppress the dustproof wall becoming air resistance.
(6) In the electronic device of any one of (1) to (5), the dustproof wall may be formed on the housing. This can increase the degree of freedom in position or posture of the dustproof wall.
(7) In the electronic device of any one of (1) to (6), the part may be a heat generating part or a heat radiating part.
(8) In the electronic device of any one of (1) to (6), an air flow path may be formed between the dustproof wall and the ventilation region of the part. Air can smoothly pass through the ventilation region of the part.
(9) In the electronic device of (8), a heat generating part or a heat radiating part may be arranged in the middle of the air flow path.
(10) In the electronic device of any one of (1) to (9), the housing has therein an air flow path formed between the vent hole and the ventilation region of the part, and the air flow path includes a flow path (for example, a flow path F2 or F4) that extends from the vent hole to the ventilation region of the part while avoiding the position of the dustproof wall.

### [Modification]

It is to be noted that the electronic device proposed in the present disclosure is not limited to the electronic device 10 described above.

For example, the part to which adhering of dust and so forth is prevented by the dustproof wall 29 may not be a power supply unit. For example, in a structure in which dust or the like entering through an intake port adheres to a heat sink, a dustproof wall may be formed between the intake port and the heat sink.

Further, depending upon the arrangement of a cooling fan, a heat generating part (for example, a power supply unit), and a heat radiating part (for example, a heat sink), air sometimes flows from the heat generating part (or the heat radiating part) toward the cooling fan and is discharged to the outside of the electronic device. In this case, a dustproof wall may be formed between an exhaust side of the heat generating part (or the heat radiating part) and an exhaust port of the electronic device. Dust and so forth entering through the exhaust port and accumulating on the exhaust side of the heat generating part (or the heat radiating part) may thus be reduced by the dustproof wall.

### [Reference Signs List]

10: Electronic device
11: Device main body
12: Upper panel
13: Lower panel
20: Housing
20A: Upper housing
20B: Lower housing
20C: Exterior panel
21: Upper wall
21a: Upper face
21c, 21d: Discharge opening
21h: Intake port
22a: Left side face
23: Right wall
24: Front wall
24a: Front face
25: Lower wall
25h: Intake port
26: Flow path wall
29: Dustproof wall
29a: Front end
29b: Rear end
31: Circuit board
33, 34: Electromagnetic shield
40: Power supply unit
40g: Exhaust hole
40h: Intake hole
41: Case
42: Right wall
42A, 42B: Intake region
42a: First right wall
42b: Second right wall
43: Upper wall
44: Rear wall
51, 52, 53: Heat sink
51a: Fin
51a1: Fin
61: Cooling fan
62: Protective plate

## Claims

1. An electronic device comprising:
a part; and
a housing that has the part accommodated therein and that has a vent hole formed therein, wherein
the vent hole is positioned in a first direction with respect to the part,
the part has, on a side thereof directed to the first direction, a ventilation region for allowing passage therethrough of air from an outside toward an inside of the part or from the inside toward the outside of the part, and
a dustproof wall is formed between the ventilation region of the part and the vent hole and stands uprightly in a second direction intersecting the first direction.

2. The electronic device according to claim **1,** wherein
the housing has therein an air flow path formed between the vent hole and the ventilation region of the part,
the housing has a wall portion that defines the air flow path, and
the wall portion has an opening formed at a position downstream of an air flow with respect to the dustproof wall.

3. The electronic device according to claim 1, wherein
an air flow path is formed between the vent hole and the ventilation region of the part, and
a height of the dustproof wall in the second direction is equal to or greater than one half of a width of the air flow path in the second direction.

4. The electronic device according to claim 1, wherein
an air flow path is formed between the vent hole and the ventilation region of the part, and
a height of the dustproof wall in the second direction is equal to or greater than two thirds of a width of the air flow path in the second direction.

5. The electronic device according to claim 1, comprising:
a cooling fan accommodated in the housing, wherein
the dustproof wall is arranged along an air flow that is formed by driving of the cooling fan.

6. The electronic device according to claim 1, wherein
the dustproof wall is formed on the housing.

7. The electronic device according to claim 1, wherein
the part is a heat generating part or a heat radiating part.

8. The electronic device according to claim 1, wherein
an air flow path is formed between the dustproof wall and
the ventilation region of the part.

9. The electronic device according to claim 8, wherein
a heat generating part or a heat radiating part is arranged in a middle of the air flow path.

10. The electronic device according to claim 1, wherein
the housing has therein an air flow path formed between the vent hole and the ventilation region of the part, and
the air flow path includes a flow path that extends from the vent hole to the ventilation region of the part while avoiding a position of the dustproof wall.
